Europäisches Patentamt

European Patent Office

Office européen des brevets

(11) Publication number: **0 046 154**

**B1**

## (12) EUROPEAN PATENT SPECIFICATION

(45) Date of publication of patent specification: **28.11.84**

(21) Application number: **80200752.6**

(22) Date of filing: **08.08.80**

(51) Int. Cl.³: **C 23 C 15/00, H 01 J 37/34**

(54) **Apparatus for coating substrates by high-rate cathodic sputtering, as well as sputtering cathode for such apparatus.**

(43) Date of publication of application:
**24.02.82 Bulletin 82/08**

(45) Publication of the grant of the patent:
**28.11.84 Bulletin 84/48**

(84) Designated Contracting States:
**AT BE CH DE FR GB IT LI LU NL SE**

(56) References cited:
**EP-A-0 025 670**
**US-A-4 169 031**
**US-A-4 175 030**
**US-A-4 179 351**

(73) Proprietor: **BATTELLE DEVELOPMENT CORPORATION**
**505 King Avenue**
**Columbus Ohio 43201 (US)**

(72) Inventor: **Zega, Bogdan**
**67, rue de Lyon**
**CH-1203 Geneva (CH)**

(74) Representative: **Dousse, Blasco et al**
**7, route de Drize**
**CH-1227 Carouge/Genève (CH)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Field of the invention

The present invention relates to an apparatus for coating substrates by high-rate cathodic sputtering, as well as to a sputtering cathode forming part of such apparatus.

Background of the invention

The recent development of high-rate cathodic sputtering, such as obtainable in particular with the use of magnetic fields (magnetically enhanced sputtering), is presently providing a major contribution to the coating field, taking into account the much higher deposition rates thus obtainable with respect to those obtained with conventional sputtering, which render therefore possible the production of coatings on an industrial scale for many applications.

The industrial production of coatings by high-rate cathodic sputtering however raises the major problem of the optimal consumption of the sputtering target, which is presently solved in none of the proposed apparatus. The requirement, for evident economical reasons, of a quasi-continuous production in industrial manufacturing as a matter of fact gives rise to a relatively fast consumption of the sputtering target, which is likely to cause, as said consumption proceeds up to the piercing of said target, some irremediable damages in all the presently known high-rate sputtering apparatus.

All the presently known high-rate sputtering apparatus are as a matter of fact designed, in view of ensuring a proper target cooling rendered, indispensable because of the high power dissipation on to it, according to one of the two following main arrangements, i.e.:

— "direct cooling" arrangement according to which the liquid coolant is circulated directly along the back of the sputtering target, in which case the target piercing would then cause some irremediable damages inside the vacuum bell jar by flooding it with the coolant (notwithstanding the risk of premature target piercing because of the high differential pressure directly exerted by the coolant on said target), and

— "indirect cooling" arrangement according to which the liquid coolant is circulated along an intermediate support against which the target in turn is mounted (said target being simply maintained in contact against said intermediate support, or on the contrary bonded to it by any suitable means), in which case the target piercing would then cause the further sputtering of the intermediate support instead of the target, whereby resulting in the irremediable damaging of the substrates being coated (notwithstanding the other drawbacks inherent to the use of an intermediate support, such as high manufacturing costs in case of a target to be bonded against the intermediate support, or lack of a good thermal contact (likely to be worsened by thermal dilation) in case of a target to be simply maintained in contact against the intermediate support).

In the presently known high-rate sputtering apparatus, the only solution adopted up to now for avoiding such irremediable damages to the apparatus and/or the substrates being coated consists therefore of simply changing the partially consumed sputtering target well before its piercing, which early target changing has besides to be performed all the more prematurely as the exact instant of the target piercing is totally unforeseeable. Such a premature changing of the sputtering target is however far from constituting an economical solution, taking into account the much more frequent stoppings thus required in the manufacturing process, as well as above all the important material losses thus incurred, especially when the target material is proved to be very costly because of its rarity and/or its difficulty to be shaped under the form desired for the target.

Outline of the invention

The present invention has precisely the object of remedying the aforementioned drawbacks, in proposing a design for high-rate cathodic sputtering which enables the target to be sputtered without damage up to its piercing, while enabling a proper target cooling throughout said sputtering.

For this purpose, the present invention relates to an apparatus for coating substrates by high-rate cathodic sputtering, which comprises an evacuable sealed enclosure; means for evacuating said enclosure and for providing therein a rarefied gas atmosphere at a pressure capable of sustaining a glow discharge; at least one sputtering cathode and one anode distant from each other, disposed at least partially inside said enclosure or forming part thereof; means for establishing between said sputtering cathode and said anode a potential difference sufficient for generating a glow discharge therebetween; and means for enhancing the sputtering about said cathode, so as to cause a high sputtering rate, wherein said sputtering cathode comprises:

— a target made of a material to be sputtered, presenting two major opposing faces of which one is designed for constituting a sputtering face,

— an intermediate support arranged in front of the face of said target opposed to said sputtering face, in such a manner as to define in combination therewith a first tight chamber of relatively low thickness, said intermediate support in turn forming part of the wall of a second tight chamber arranged adjacent to said first tight chamber,

— means for providing inside said first tight chamber an atmosphere of a gaz presenting a high thermal conductivity, at a pressure higher than that prevailing in said sealed enclosure, and,

— means for circulating a liquid coolant within said second tight chamber,

and wherein said apparatus further comprises:

— means for detecting a sudden irruption, inside said sealed enclosure, of said high thermally-conducting gas normally contained inside said first tight chamber, and,

— means for controlling the switch-off of said apparatus as soon as said sudden irruption of gas is detected, whereby enabling said target to be sputtered up to its piercing without damage for said apparatus and/or substrates while enabling a proper target cooling throughout said sputtering.

The present invention also relates to a sputtering cathode for such an apparatus.

In the present specification, the expression "high-rate cathodic sputtering" intends to designate any type of cathodic sputtering process (non-reactive or reactive sputtering, and/or direct-current or radio-frequency sputtering) in which there is made use of enhancing means capable of giving rise to sputtering rates much higher than those obtainable with conventional sputtering, i.e. at the very least any type of cathodic sputtering process in which the target consumption begins to be carried out at a rate sufficiently high for raising the problem of its periodic replacement. As it is well known, such enhanced-sputtering processes may be carried out in a particularly advantageous manner thanks to the application of magnetic fields inside the interspace cathode-anode of the sputtering apparatus (magnetically enhanced sputtering), which magnetic fields may assume various configurations; axial uniform magnetic fields, such as likely to be generated by systems of the Penning-type (constituted by Helmholtz-type coils disposed outside the vacuum bell jar), or tunnel-shaped magnetic fields extending in a closed path adjacent to the sputtering target, such as likely to be generated by the so-called "planar" or "cylindrical magnetrons" (constituted by appropriate magnet assemblies arranged behind the back of the intermediate support), etc. Such "cylindrical magnetrons" may in particular be constituted by those of the type described in EP—A1—0045022 (filed the same day), which is hereby incorporated by reference.

In an alternative manner, the above-defined enhanced-sputtering processes may also be carried out by enhancing means other than magnetic means, such as for instance by that used in connection with triode sputtering, etc.

It may thus be seen that one of the essential features of the present invention lies in the inter-position of a relatively thin layer of a stagnant gas with a high thermal conductivity between the conventional liquid cooling circuit and the back of the sputtering target, the function of which is essentially of enabling the comsumption of said target up to its piercing without causing any damage for the sputtering apparatus and for the substrates being coated, while further providing a sufficient target cooling throughout its sputtering.

Such interposition of an additional stagnant gas layer as a matter of fact firstly presents the major advantage of enabling a totally harmless detection of the exact instant of piercing of the sputtering target—since this piercing will result in a simple irruption of gas inside the vacuum bell jar, which gas, irruption can then be at once detected for immediately controlling the automatic cut-off of the sputtering apparatus— whereby authorizing an optimal consumption of the sputtering target, in connectino with a complete automatization of the apparatus functioning (except at the time of the replacement of the completely eroded target).

The detection of the gas irruption inside the vacuum bell jar in view of controlling the automatic cut-off of the sputtering apparatus may be carried out by various ways. Such a detection may thus be carried out by determining the sudden pressure variations likely to occur at the instant of target piercing (sudden rise of pressure inside the vacuum bell jar or sudden decrease of pressure inside the chamber normally containing the stagnant gas layer), thanks for instance to the use of adequate means for measuring the pressure prevailing at any instant inside the vacuum bell jar or inside the chamber normally containing said stagnant gas layer. Such a detection may equally be carried out by observing the apparition of the characteristic light likely to be emitted at the instant of target piercing (characteristic light likely to be emitted by said high thermally-conducting gas when undergoing an electrical discharge at its entrance inside the vacuum bell jar), thanks to the use of adequate spectroscopical means (for instance photoelectric cell fitted with an appropriate optical filter) for determining the apparition of such a characteristic light. For enabling the above detection, the pressure of said interposed stagnant gas layer will be chosen substantially higher than that prevailing in the vacuum bell jar (pressure in the bell jar of the order of $10^{-4}$ to $10^{-2}$ torr ($1.33322 \times 10^{-2}$ to $1.33322$ Pa) for enabling the proper sustaining of the glow discharge), so as to give rise to sufficiently detectable pressure variations at the time of the target piercing. This pressure will nevertheless be chosen not too high, so as to avoid any risk of premature target piercing likely to result because of the application of a too high differential pressure on the target becoming progressively thinner. The pressure of said interposed stagnant gas layer will therefore be advantageously chosen so as to be comprised between $10^{-1}$ and 200 torr (between 13.3322 and $2.66644 \times 10^4$ Pa), the preferred ranges for said pressure besides lying between 1 and 10 torr (between $1.33322 \times 10^2$ and $1.33322 \times 10^3$ Pa).

Such interposition of an additional stagnant gas layer between the sputtering target and the liquid coolant circuit furthermore enables the ensuring of a sufficient target cooling throughout its sputtering taking into account the choice of a gas having a sufficiently high thermal conductivity combined with the choice of a sufficiently low thickness for said gas layer, which therefore authorizes a heat flow through said gaz layer which is proved to be sufficiently high for maintaining the temperature of the sputtering target to acceptable values.

It may as a matter of fact be assumed that the sputtering target can easily tolerate temperature rises up to values of the order of 500°C without causing any harmful damage for the sputtering process, taking into account that such values will still remain too low for being able in most cases to cause some deterioration (cracking, sublimation or melting) of the sputtering target, as well as a too prohibitive radiative heating up of the substrates being coated (radiative heating up proportional to the fourth power of the temperature, which still remains tolerable for values of the order of 500°C).

It is furthermore known that the heat flow per unit time and unit area "$dQ/dt$" through a gaz layer of thickness "$e$" stagnating between two plates with respective temperatures "$T$" and "$T_o$" obeys to the general relation:

$$dQ/dt = k(T - T_o)e$$

where k designates the thermal conductivity of said gas, which is proved to be independent of its pressure provided that said pressure substantially exceeds a minimum value from which the mean free path of the gas becomes of the same order as the distance separating the plates between which the heat is transported (which condition is fully met with the values claimed in the present invention).

From the above considerations, it may therefore be clearly seen that in spite of the high power dissipation at the target usually encountered in high-rate sputtering (power dissipation typically of the order of 20 Watt/cm²), the temperature of said target may be easily kept below the maximum permissible values (typically below values of the order of 500°C), by choosing, for the interposed stagnant gas layer, some gases having sufficiently high thermal conductivities such as helium

$(k=4.1060 \times 333 \times 10^{-6}$ J/sec×cm×°C at 20°C),

hydrogen

$(k=4.1060 \times 405 \times 10^{-6}$ J/sec×cm×°C at 20°C),

neon

$(k=4.1050 \times 107 \times 10^{-6}$ Jsec×cm×°C at 20°C),

etc., together with gas layers having sufficient low thicknesses, likely to be advantageously comprised between 0,05 and 1 mm (preferred thickness ranges lying between 0,1 and 0,3 mm).

The sputtering cathode and apparatus of the present invention may, in function of the different envisaged coating applications, be designed so as to assume various geometrical configurations, amongst which one may in particular distinguish cylindrical and planar configurations. These cylindrical configurations may in turn assume one of the two following main types:

— apparatus with a central cylindrical sputtering cathode, designed for coating substrates disposed concentrically outside the central cathode (for instance single tubular substrate disposed coaxially around said cathode so as to be internally coated, or plurality of planar substrates disposed equiangularly around said cathode). The central sputtering cathode will in such a case consist of a tubular sputtering target arranged coaxially outside a tubular intermediate support, so as to define therebetween an annular tight chamber of low thickness intended to be filled with the appropriate atmosphere of gas with high thermal conductivity (the inside of said tubular intermediate support being besides able to constitute a second tight chamber intended to be circulated with an appropriate liquid coolant such as cold water);

— apparatus with a hollow cylindrical sputtering cathode, designed for coating substrates inserted axially inside said hollow cathode (for instance rod-like or tubular substrate to be externally coated). The hollow sputtering cathode will in such a case consist of a tubular sputtering target arranged coaxially inside a tubular intermediate support, so as to define therebetween an annular tight chamber of low thickness intended to be filled with said appropriate atmosphere of gas with high thermal conductivity (said tubular intermediate support being besides able to constitute part of the wall of a second tight chamber arranged against its external face, which is intended to be circulated with the appropriate liquid coolant).

The planar configurations of the present invention will for their part concern apparatus with a planar sputtering cathode, consisting of a planar sputtering target arranged in front of a planar intermediate support, so as to define therebetween a sheet-like tight chamber intended to be filled with the appropriate atmosphere of gas with high-thermal conductivity (said planar intermediate support being besides able to constitute part of the wall of a second tight chamber arranged against its remote face, which is intended to be circulated with the appropriate liquid coolant).

In the apparatus of the present invention, the anode may finally be constituted by the substrate proper (said substrate being therefore grounded while the cathode is negatively biased to a high voltage), or on the contrary by an intermediate grid interposed between the substrate and the cathode (said intermediate grid being therefore grounded or positively biased, while the substrate may be negatively or positively biased, or still left "floating").

Brief description of the drawings

The accompanying drawings are diagrammatic illustrations by way of example of several embodiments of the apparatus according to the present invention.

Fig. 1 is a diagrammatic sectional view of a first embodiment.

Fig. 2 is a perspective view of an element constitutive of the cathode of this first embodiment, drawn to a larger scale.

Fig. 3 is a cross-sectional view according to line III—III of Fig. 2.

Fig. 4 is a perspective view similar to that of Fig. 2, showing the outside of said cathode.

Fig. 5 is a diagrammatic sectional view similar to that of Fig. 1, illustrating one variation of the first embodiment.

Fig. 6 is a diagrammatic sectional view similar to that of Fig. 1, illustrating a second embodiment.

Fig. 7 is a diagrammatic sectional view similar to that of Fig. 1, illustrating a third embodiment.

Specific description

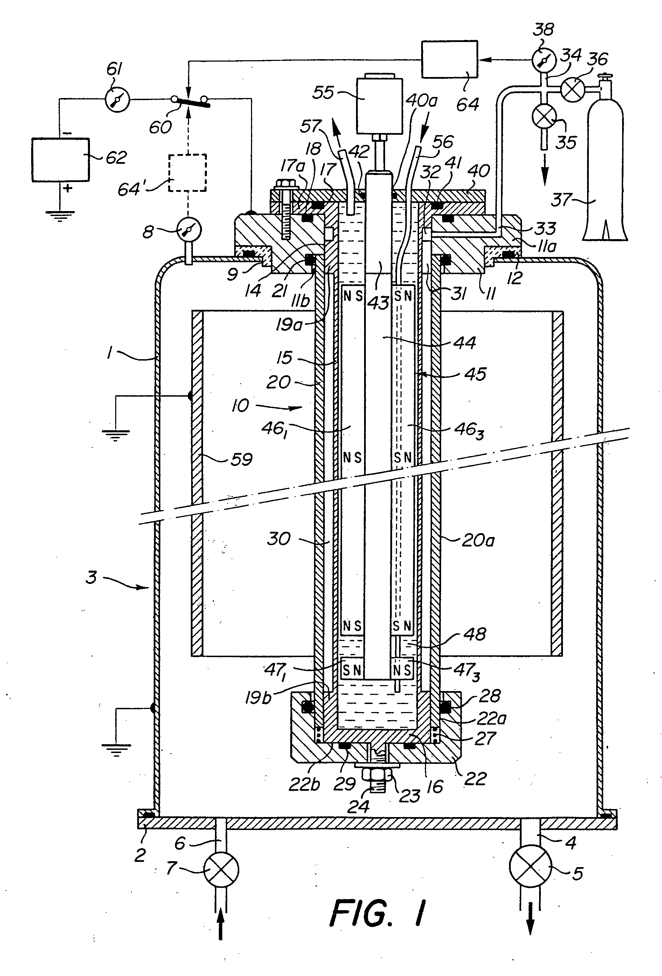

The figures 1 to 4 relate to a first embodiment of the apparatus of the present invention, according to which there is made use of a cylindrical magnetron sputtering cathode extending centrally inside said apparatus, so as to enable the coating of substrates disposed concentrically around said cylindrical cathode.

This first embodiment of Figs. 1 to 4 comprises (Fig. 1) a bell jar 1 resting on a base plate 2, so as to form a sealed enclosure 3. The base plate 2 is provided with an evacuation port 4 connected via a valve 5 to a suitable pumping device (not shown), and with an admission port 6 connected by a gauged valve 7 to a source of an appropriate gas such as argon (not shown). The bell jar 1 is further provided with a pressure gauge 8.

Through a central circular opening 9 provided in the top of the bell jar 1 is introduced a cylindrical magnetron sputtering cathode 10, which extends centrally inside the sealed enclosure 3. This cylindrical cathode 10 comprises at its upper end a discoidal metal block 11, which rests by means of an external flange 11a on the border of the opening 9, via an insulating ring 12. The discoidal metal block 11 is in turn provided with a central circular opening 14, through which is introduced a tubular sheath 15 with a flat bottom 16 and an open top 17, which rests by means of a top external flange 17a against the upper plane face of the block 11 (tightness between the flange 17a and the block 11 ensured by a O-ring 18). The tubular sheath 15, which is made of a high thermally-conducting material such as copper, is further provided at both lateral ends with respective external annular shoulders 19a and 19b of low thickness, dimensioned for closely fitting the internal diameter of the central opening 14 of the block 11.

Around the tubular sheath 15 is in turn coaxially mounted an open-ended tubular target 20 made of a material to be sputtered, internally dimensioned for closely fitting the respective end-shoulders 19a and 19b of the tubular sheath 15. The upper end of the tubular target 20 protrudes inside an annular recess 11b provided in the lower part of the block 11 for enlarging the corresponding lower part of the opening 14, so that this upper end of target 20 is firmly inserted between the lateral wall of the recess 11b and the shoulder 19a of the tubular sheath 15 (tightness between the target 20 and the block 11 ensured by a O-ring 21 disposed in an annular groove provided in the lateral wall of recess 11b). The lower end of the tubular target 20, which rests by its internal wall against the end-shoulder 19b of sheath 15, is in turn closely surrounded by the lateral wall 22a of a cup-shaped closing element 22, the bottom 22b of which is maintained in close contact against the bottom 16 of the sheath 15 by means of a nut 23 cooperating with a screw 24 integral with the bottom 16 (screw 24 protruding below the bottom 22b through a central hole provided in said bottom 22b). In the annular space between the shoulder 19b of the sheath 15 and the lateral wall 22a of the closing element 22 is besides mounted an annular spring 27, compressed between the bottom 22b of closing element 22 and the lower end of the target 20 so as to keep the upper end of said target 20 tightly inserted inside the recess 11b of the block 11, whatever the thermal dilatation likely to be incurred by said target 20 (the tightness between the lower end of target 20 and the lateral wall 22a of closing element 22 being ensured by a O-ring 28 disposed in an annular groove provided in the lateral wall 22a, while the tightness between the respective bottoms 16 and 22b is ensured by a O-ring 29 disposed in an annular groove provided in the upper face of bottom 22b).

The thus coaxially mounted tubular sheath 15 and tubular target 20 therefore delimitate an annular tight chamber 30 of low thickness therebetween, which axially extends from the top metal block 11 to the bottom closing element 22 of the sputtering cathode 10 (the tightness of said chamber 30 being ensured by the respective O-rings 18, 21, 28 and 29). The tubular sheath 15 and tubular target 20 are dimensioned with respect to each other (adequate choice of the internal diameter of the target 20 with respect to the external diameter of sheath 15 and the thickness of the shoulders 19) so as to delimitate an annular chamber 30 presenting an internal thickness preferably comprised between 0.1 and 0.3 mm (thickness strongly exaggerated with respect to the other dimensions on the drawing, for purposes of better understanding).

This annular tight chamber 30 is besides connected to the outside of the sealed enclosure 3 thanks to the providing, in the upper end-shoulder 19a of the sheath 15, of a plurality of equiangularly spaced axially extending channels 31 emerging in an annular groove 32, which annular groove 32 in turn freely communicates with the outside by means of a conduit 33 adequately pierced through the block 11. The outside emerging end of the conduit 33 is in turn connected to the first branch of a four-branch junction 34, the second branch of which is connected via a valve 35 to a suitable pumping device (not shown), the third branch of which is connected via a gauged valve 36 to a source 37 of a high thermally-conducting gas (such as helium), and the fourth branch of which is connected to a pressure gauge 38.

The open top 17 of the tubular sheath 15 is closed by a plane cover 40 resting on the upper plane face of the flange 17a (the tightness between the cover 40 and the flange 17a being ensured by a O-ring 41 disposed in an annular groove provided in the upper face of said flange 17a). Through a central circular opening 40a provided in the cover 40 is inserted a cylindrical stud 43 (the tightness between the cover 40 and the stud 43 being ensured by an adequate O-ring 42), to the lower end of which is connected a soft iron rod 44 with a square cross-section, which centrally extends inside the tubular sheath 15 substantially along the whole length of the annular chamber 30.

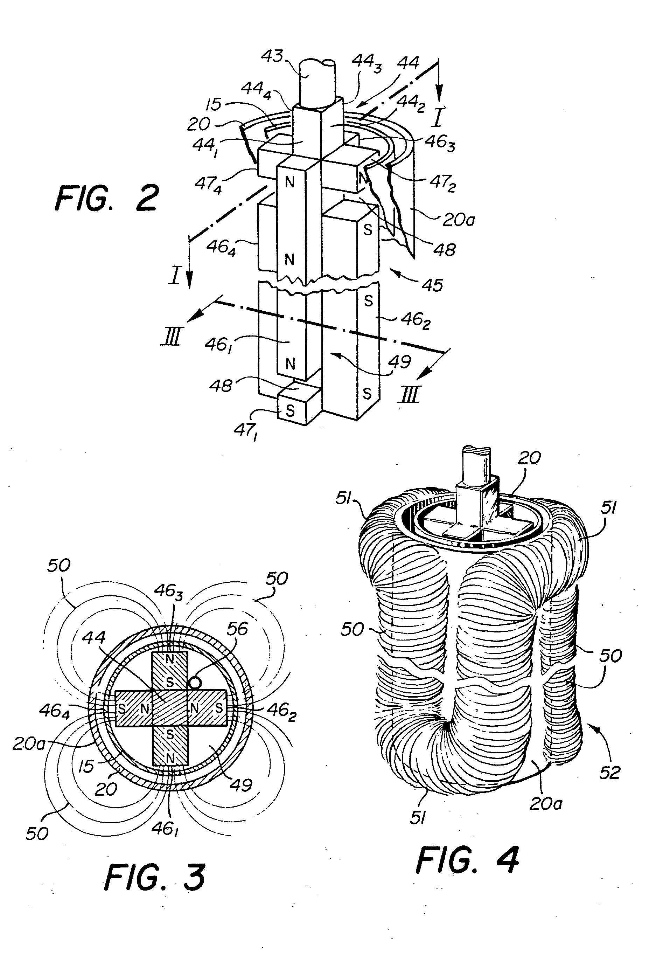

Around this soft iron central rod 44 is mounted a magnet assembly 45, designed for generating magnetic fields having flux lines which project in a curve from the outer sputtering face 20a of the tubular target 20 and return thereto to form arch portions thereover (flux lines successively traversing the tubular sheath 15 and the tubular target 20 made of non-magnetic materials). This magnet assembly 45, which is better shown on the perspective view of Fig. 2 (magnet assembly 45 shown in Fig. 1 in a sectional view according to lines I—I of Fig. 2), consists of a plurality of equiangularly spaced axially extending radially magnetized magnets $46_1$ to $46_4$ and $47_1$ to $47_4$, which are arranged against the four longitudinal faces of the central rod 44 in the following manner:

— parallelepipedic magnets $46_1$ and $46_3$, coupled by their south pole faces against the respective opposite faces $44_1$ and $44_3$ of the central rod 44 so as to have their north pole faces pointing in the vicinity of the inner wall of the tubular sheath 15, said parallelepipedic magnets $46_1$ and $46_3$ extending along the central rod 44 from its upper end portion to an intermediate portion situated immediately upward its lower end portion,

— parallelepipedic magnets $46_2$ and $46_4$, coupled by their north pole faces against the respective opposite faces $44_2$ and $44_4$ of the central rod 44 so as to have their south pole faces pointing in the vicinity of the inner wall of the tubular sheat 15, said parallelepipedic magnets $46_2$ and $46_4$ extending along the central rod 44 from its lower end portion to an intermediate portion situated immediately below its upper end portion,

— cubic end-magnets $47_1$ and $47_3$, coupled against the lower end portion of the respective opposing faces $44_1$ and $44_3$ of the central rod 44 so as to extend in the prolongation of the corresponding parallelepipedic magnets $46_1$ and $46_3$ while being separated from the latter by gaps 48, said cubic end-magnets $47_1$ and $47_3$ being coupled by their north pole faces against the lower end portions of said opposing faces $44_1$ and $44_3$ so as to have their south pole faces pointing in the vicinity of the inner wall of the tubular sheath 15, and,

— cubic end-magnets $47_2$ and $47_4$, coupled against the upper end portion of the respective opposing faces $44_2$ and $44_4$ of the central rod 44 so as to extend in the prolongation of the corresponding parallelepipedic magnets $46_2$ and $46_4$ while being separated from the latter by gaps 48, said cubic end-magnets $47_2$ and $47_4$ being coupled by their south pole faces against the upper end portions of said opposing faces $44_2$ and $44_4$ so as to have their north pole faces pointing in the vicinity of the inner wall of the tubular sheath 15.

The above-described plurality of magnets $46_1$ to $46_4$ and $47_1$ to $47_4$ constitutive of the magnet assembly 45 inserted inside the tubular sheath 15 is therefore arranged in such a manner as to generate flux lines which form over the outer sputtering face 20a of the tubular target 20 (Figs. 3 and 4) four equiangularly spaced axially extending straight arch portions 50 alternately connected to one another by four arcuate arch end-portions 51, whereby defining a single closed-loop arch 52 extending in a meandering manner over the entire circumference of the sputtering face 20a of said tubular target 20.

The upper end of the cylindrical stud 43 protruding outside the cover 40 is besides connected (Fig. 1) to the shaft of a motor 55, designed for slowly rotating the magnet assembly 45 according to a to-and-fro rotatory movement, of an amplitude sufficient (about $\pm 45°$) for enabling the single closed-loop arch 52 generated by said magnet assembly 45 to be periodically scanned over the entire surface of the sputtering face 20a.

The closed tubular sheath 15 containing the magnet assembly 45 is furthermore provided with a circuit for circulating a liquid coolant such as cold water therewithin. This circuit comprises at least one admission conduit 56 extending from the outside of the cover 40 to near the bottom 16 of the sheath 15 (while traversing the magnet assembly 45 by extending along the corner of one of the longitudinal spaces 49 deliminated between the equiangularly spaced magnets 46 and 47), so as to bring the liquid coolant down to the bottom 16 of said sheath 15 (outside protruding end of the conduit 56 connected to a suitable liquid coolant source not shown on the drawing). The liquid coolant thus brought down to the bottom 16 can then freely flow upwards, by circulating along the free longitudinal spaces 49 delimitated between the equiangularly spaced different magnets 46 and 47, before being evacuated through an evacuating port 57 provided in the cover 40.

Inside the sealed enclosure 3 is finally disposed a tubular metal substrate 59 to be internally coated, arranged coaxially around the tubular target 20 of the central cylindrical cathode 10. The tubular metal substrate 59 is connected to ground (as well as the metal enclosure 3), while the central cathode 10 is connected via a switch 60 and an ampere-meter 61 to the negative pole of a high-voltage source 62 whose other pole is also grounded.

The above apparatus finally comprises a control circuit 64, respectively connected by its input to the pressure gauge 38 and by its output to the switch 60. This control circuit 64 is designed for triggering the opening of the switch 60, as soon as the pressure recorded by the gauge 38 undergoes a sudden decrease with respect to a predetermined value.

The above-described sputtering apparatus operates in the following manner:

The cylindrical cathode 10 being provided with a new unconsumed target 20, the sealed enclosure 3 is evacuated and an argon atmosphere of the order $10^{-4}$ to $10^{-2}$ torr ($1.33322 \times 10^{-2}$ to $1.33322$ Pa) is introduced therein. Concurrently, the annular chamber 30 of the cathode 10 is also evacuated (by pumping means connected to the valve 35) and an helium atmosphere of the order of 10 torr ($1.33322 \times 10^3$ Pa) is introduced therein (by means of the gauged valve 36 connected to the helium source 37).

The liquid coolant being then circulated inside the tubular sheath 15 of the cathode 10, the switch 60 is closed, whereby causing the application of a negative high voltage to said cathode 10.

The negative biasing of the cathode 10 then produces in a known manner a glow discharge in the neighborhood thereof, which causes ionization of the argon atoms. The argon ions thus formed then bombard the sputtering face 20a of the tubular target 20, whereby causing the ejection (or sputtering) of atoms from said sputtering face 20a, which sputtered atoms are then deposited by condensation on the internal face of the tubular substrate 59.

The presence of the magnet assembly 45 inside the cylindrical cathode 10 has for effect of confining the discharge plasma (ionization region) within the closed-loop endless arch 52 formed over the sputtering face 20a by the flux lines of said magnet assembly 45, while concurrently producing a very high intensification of this discharge plasma. The formation of such an intense and confined discharge plasma may be explained in a known manner by the fact that the closed loop endless arch 52 generated by the magnet assembly 45 acts, with respect to the seondary electrons emitted by the target 20, as a trapping means which compels these secondary electrons to circulate along an extended continuous path around the sputtering surface 20a instead of directly migrating towards the anode, whereby drastically increasing the probability of ionizing collisions with argon atoms. The production of such an intense and confined discharge plasma therefore results in an intense ion bombarding of the sputtering face 20a of the target 20 (large ion current bombarding of the cathode), whereby causing an intense sputtering of said target 20, and thus the coating with a high deposition rate of the internal face of the tubular substrate 59.

The intense ion bombardment to which the target 20 is thus submitted however causes a high power dissipation at the target, whereby requiring a sufficient target cooling throughout the sputtering in view of preventing any damaging risk (possible deterioration of the target 20, and/or too high radiative heating of the substrate 59, and/or possible demagnetization of the magnet assembly 45). Such a sufficient target cooling throughout the sputtering is precisely ensured by the double cooling system provided in the present apparatus, i.e. the closed tubular sheat 15 containing the magnet assembly 45, which is provided with a liquid coolant circuit, and the annular chamber 30 of low thickness coaxially extending between this tubular sheath 15 and the back of the target 20, which is provided with an atmosphere of a high thermally conducting gas such as helium. The interposition of a stagnant helium layer of low thickness between the target 20 and the sheath 15 as a matter of fact authorizes, in spite of the high power dissipation at the target, a permanent heat transfer from the target 20 to the sheath 15 (through said helium layer) which is proved to be sufficiently high for keeping the temperature of said target 20 down to maximum permissible values of the order of 500°C, provided that the temperature of said sheath 15 is for its part kept about the ambient value. The maintaining of the sheath 15 about the ambient value is precisely ensured by the liquid coolant circulated inside the sheath 15, which continuously evacuates towards the outside the heat continuously transferred through the helium gas layer of low thickness. The evacuation of such heat towards the outside is precisely all the better as the liquid coolant can freely circulate along the longitudinal spaces 49 delimitated between the equiangularly spaced different magnets 46 and 47, i.e. along longitudinal spaces 49 which precisely extend in front of the regions of the target 20 where the sputtering (and thus the power dissipation) is the more intense.

As the sputtering proceeds, the target 20 undergoes a progressive erosion, which would in principle remain localised in the only regions of the target covered by the closed-loop confined discharge plasma (i.e. in the regions covered by the closed-loop arch 52 formed by the flux lines of the magnet assembly 45.) The providing of the motor 55 for slowly rotating the magnet assembly 45 according to an oscillatory rotary movement with respect to the target 20 has however precisely for object of ensuring a uniform erosion of said target 20 (whereby resulting in an improved target life), by periodically scanning the closed-loop arch 52 (and thus the intense discharge plasma confined inside said arch 52) over the entire surface of the sputtering face 20a. The uniformity of the target erosion is furthermore all the better as there is produced a single closed-loop plasma meandering over the entire circumference of the sputtering face, whereby resulting in a practically uniform plasma current along its whole path. The above providing of the motor 55 for slowly rotating the magnet assembly 45 in turn results in a similar oscillatory rotational movement of said magnet assembly 45 with respect to the substrate 59, whereby giving rise to an excellent uniformity as regards the internal coating of the substrate 59.

When the substrate 59 is provided with a uniform coating of desired thickness, the sputtering operation is temporarily stopped so as to enable the replacement of said coated substrate by a new uncoated one, and the sputtering operation can then be immediately restarted. Throughout the successive coating of different substrates, the sputtering target 20 continues to be progressively eroded, whereby giving rise to its piercing at certain unforeseeable moment of the sputtering operation. Such a piercing is however proved to be totally harmful for the sputtering apparatus and/or the substrates being coated, since it results in a simple irruption of helium inside the sealed enclosure 3, which is at once detected by the pressure gauge 38 (gauge 38 detecting a sudden decrease of helium pressure inside the annular chamber 30) for immediately controlling by means of the controlling circuit 64, the automatic cut-off of the switch 60 of the sputtering apparatus. The pierced target 20, the consumption (and thus the lifetime) of which has been therefore optimized, can then be immediately removed from the sealed enclosure for being replaced by a new fresh one, and the sputtering operation can then be restarted for continuing the substrate coating.

In the above-described operation, the coating of each substrate 59 may besides, if desired, be preceded by a cleaning step, which cleaning step may be carried out in a known manner by negatively biasing said substrate 59 while the cylindrical cathode 10 is grounded (said biasing, which is the reverse of that applied during the coating, giving rise in a known manner to the generation of a glow discharge causing the proper sputtering of said substrate).

According to the variation of the above-described embodiment, the control circuit 64 may be replaced by a control circuit 64' (shown in dotted lines on Fig. 1) having its input connected to the pressure gauge 8 provided in the enclosure 3 (instead of being connected to the pressure gauge 38 as previously), so as to control the automatic cut-off of the sputtering apparatus as soon as this gauge 8 detects a sudden increase of pressure inside the sealed enclosure 3 (instead of detecting a sudden decrease of pressure inside the annular chamber 30 as previously).

According to another variation of the above-described embodiment, the means for detecting the sudden irruption of helium inside the main enclosure may be constituted by adequate spectroscopical means for observing the apparition of the characteristic light likely to be emitted at the instant of target piercing (characteristic light likely to be emitted by helium when submitted to a glow discharge at its entrance inside the main enclosure), instead of the pressure measuring means previously described. Such spectroscopical means, which may for instance be constituted by a photoelectric cell fitted with an appropriate optical filter (not shown on the drawing), will be connected to the controlling circuit 64 as previously, so as to control the automatic cut-off of the sputtering apparatus as soon as the apparition of the characteristic light is detected.

According to still another variation of the above-described embodiment, the motor 55 for moving the magnet assembly 45 may be designed for rotating this assembly 45 according to a unidirectional rotary movement instead of the to-and-fro rotary movement previously described (the admission conduit 56 extending along one of the channels 49 of the magnet assembly 45 being in such a case advantageously replaced by a borehole, pierced through the stud 43 and the rod 44 so as to axially extend from the upper end of said stud 43 to the lower end of said rod 44), so as to cause full revolutions of the magnet assembly 45 with respect to the tubular target 20 and the substrate 59, whereby resulting in an effect similar to that previously described as regards the good uniformity of target sputtering as well as that of substrate coating.

Example

The sputtering apparatus of Figs. 1 to 4 is used for depositing a stainless steel coating of about 10 $\mu$m thick (for corrosion protection purposes) on the internal surface of soft iron tubes having a length of the order of 400 mm as well as an internal diameter of the order of 70 mm.

For such a deposition, the sputtering apparatus of Figs. 1 to 4 makes use of a cylindrical cathode 10 presenting the following structural parameters:

— tubular sheath 15 made of copper, presenting an external diameter of the order of 31.6 mm,
— tubular target 20 made of 18/8 stainless steel (stainless steel 304 according to US designation), presenting an internal diameter of the order of 32 mm (tubular sheath 15 and tubular target 20 therefore delimitating therebetween an annular chamber 30 having a thickness of the order of 0.2 mm), which tubular target 20 furthermore presents an initial thickness of the order of 1.5 mm, as well as an overall length of the order of 500 mm (tightness at both ends ensured by O-rings 21 and 28 made of Viton®),
— magnet assembly 45 designed so as to generate in the vicinity of the sputtering face 20a of the target 20 magnetic fields having a strength of the order of 300 to 800 Oersteds (depending on the actual erosion level of the target), said magnet assembly 45 being furthermore arranged inside the target 20 so as to cause the erosion of the latter along a length of about 450 mm.

The pressure gauge 38 provided in this sputtering apparatus is besides constituted by a gauge of trademark Balzers APGO10/APRO10, covering the range of 0.1 to 1000mbar and giving an electrical output signal of 100 mV to 10 mbar (output signal connected to the controlling circuit 64).

A first soft iron tube 59 to be coated having been arranged concentrically around the cylindrical cathode 10, the sealed enclosure 3 is evacuated to a pressure of about $1.10^{-5}$ mbar (via the valve 5), simultaneously with the chamber 20 (via the valve 35). The evacuating operation once terminated, the valve 35 is closed, and an atmosphere of helium up to a pressure of the order of 10 mbar is introduced inside the chamber 20 (via the gauged valve 36), while an atmosphere of argon up to a pressure of the order of $2.10^{-2}$ mbar is simultaneously provided inside the main enclosure 3 (via the valve 7).

The soft iron tube 59 is then submitted to a short cleaning prior to its coating, by biasing the iron tube 59 to a value of the order of −500 to −1000 volts while the magnetron cathode 10 is grounded (the glow discharge thus appearing between the tube and the magnetron cathode being maintained during about 5 min., so as to cause a sputtering of the internal surface of said tube which is sufficient for properly cleaning it).

The above cleaning once terminated (by switching off the above biasing), the pressure of argon inside the main enclosure 3 is decreased up to a value of the order of $4.10^{-3}$ mbar, in view of operating the coating proper of the tube 59. For that purpose, the tube 59 is grounded, while the magnetron cathode 10 is connected via the switch 60 (as shown on the drawing) to the negative pole of a DC power supply 62 delivering up to 12 Amps at about 500 Volts (the power supply 62 being besides protected against arcing by a current limiter). The deposition rate onto the internal surface of the tube is about 6 $\mu$m per kWh consumed, while the corresponding target erosion rate is about 12 $\mu$m per kWh consumed. Using a power of 6kW, the desired coating of about 10 $\mu$m thick onto the internal surface of the tube is therefore deposited in about 17 min. Under the above conditions, the maximum temperature reached by the target is of about 500°C in the sputtering zone, while not exceeding 200°C at both ends (i.e. in the vicinity of the O-rings 21 and 28).

The above operations are cyclicly repeated for the coating of successive tubes 59, whereby leading to a progressive erosion of the target 20, up to its piercing after about 20 hours of operation. At the exact instant of piercing, the brusque irruption of helium inside the main enclosure 3 is immediately detected by the fast reacting gauge 38, the output signal of which is at once treated by the controlling circuit 64 for switching off the sputtering apparatus. The consumed target 20 may then be replaced by a new one, and the deposition further continued, without any damage for the tubes being coated.

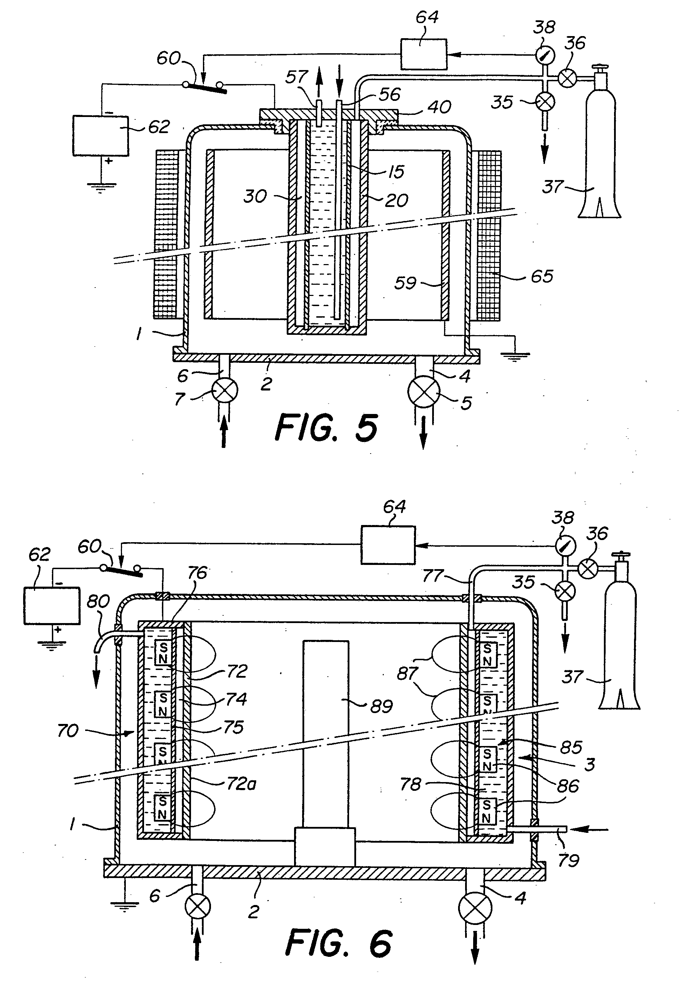

The figure 5 illustrates still another variation of the first embodiment of Figs. 1 to 4 (the unchanged elements keeping the same figures of reference on the drawing), according to which the magnet assembly 45 inserted inside the central cylindrical cathode 10 is suppressed, and replaced by a coil of the Helmholtz-type 65 disposed concentrically outside the bell jar 1 (bell jar 1 made of a non-magnetic material such as stainless steel), so as to ensure the generation of an axial uniform magnetic field inside the annular interspace extending between the target 20 and the substrate 59. The operation of this apparatus of Fig. 5 is in any respect similar to that previously described, except that the sputtering rates there obtained are substantially lower, taking into account the uniformity of the magnetic field thus applied which causes a simple intensification, but without confinement, of the discharge plasma (coil 65 also acting as a means for enhancing the discharge plasma, but in a manner less performant than that likely to be carried out by the magnet assembly 45). The apparatus of Fig. 5 is furthermore limited to the coating of tubular substrates 59 made of non-magnetic materials (substrate 59 as well as bell jar 1 having as a matter of fact to be non-magnetic, in order not to shield the magnetic field generated from the outside by the coil 65).

The Fig. 6 relates to a second embodiment of the apparatus of the present invention, according to which there is made use of a hollow magnetron sputtering cathode disposed concentrically around the axis of the apparatus, so as to enable the external coating of substrates centrally extending along said axis (the elements of said embodiment of Fig. 6 which are unchanged with respect to those of Figs. 1 to 4 remaining allocated with the same figures of reference on the drawing).

This embodiment of Fig. 6 again comprises a bell jar 1 resting on a baseplate 2 so as to form a sealed enclosure 3, as well as an evacuation port 4 and an admission port 6 provided in said baseplate 2. Inside the sealed enclosure 3 is disposed a hollow magnetron sputtering cathode 70, extending concentrically around the vertical axis of said enclosure 3. This hollow cathode 70 comprises a tubular target 72 made of a material to be sputtered, concentrically arranged inside a tubular intermediate support 75. The tubular target 72 extends at short distance from the tubular support 75, so as to delimitate in combination therewith a first tight chamber 74 of low thickness (chamber 74 closed at both ends by flanges 76 radially protruding from the support 75). This tight chamber 74 is connected to the outside of the sealed enclosure 3 by means of a conduit 77, which is in turn connected to the same elements as previously (i.e., respectively, to adequate pumping means via the valve 35, to the helium source 37 via the gauged valve 36, and to the pressure gauge 38).

The tubular intermediate support 75 in turn forms part of the wall of a second tight chamber 78 adjoining said first tight chamber 74, which second chamber 78 is respectively provided with an admission conduit 79 and an evacuation conduit 80 for enabling the circulation of a liquid coolant such as cold water therewithin. Inside this chamber 78 is besides mounted a magnet assembly 85, consisting of a plurality of equiaxially spaced circumferentially extending axially magnetized ring magnets 86. These ring magnets 86 are coupled against the back-face of the tubular support 75 so as to generate magnetic fields having flux lines which form a plurality of equiaxially spaced toroidal arches 87 circumferentially extending over the sputtering face 72a of the tubular target 72.

Centrally inside the sealed enclosure 3 is finally disposed a cylindrical substrate 89 to be externally coated. This central substrate 89 is connected to ground, while the hollow cathode 70 is connected as previously (via the switch 60) to the negative pole of the high-voltage source 62 whose other pole is also grounded. The apparatus of Fig. 6 is finally also provided with the control circuit 64, respectively connected by its input to the pressure gauge 38 and by its output to the switch 60.

The operation of the above-described apparatus is in many respects similar to that previously described:

The sealed enclosure 3 and the first tight chamber 74 being respectively provided with an atmosphere of argon of the order of $10^{-4}$ to $10^{-2}$ torr ($1.33322 \times 10^{-2}$ to $1.33322$ Pa) and with an atmosphere of helium of the order of 10 torr ($1.33322 \times 10^3$ Pa), the liquid coolant is then circulated inside the second tight chamber 78 while a negative high voltage is applied to the hollow cathode 70 (by closing the switch 60). The application of this negative high voltage leads to the formation of a plurality of intense ring plasmas confined within the toroidal arches generated by the ring magnets 86 over the inner face 72a of the target 72, whereby causing an intense sputtering of the corresponding regions of said target 72, and therefore a high-rate coating of the central substrate 89 (target 72 however likely to be uniformly eroded thanks to the providing of an adequate to-and-fro axial moving of the magnets 86 with respect to the target 72).

Throughout said intense sputtering, an excessive heating of the target 72 is prevented thanks to the presence of the double cooling system provided in the apparatus, i.e. the atmosphere of a high thermally conducting gas such as helium provided in the first chamber 74 of low thickness adjoining the back face of the target 72, and the liquid coolant circuit provided in the second chamber 78 adjoining said first chamber 74. The target cooling thus carried out is however less satisfactory than that obtained with the embodiment of Figs. 1 to 4, since in this case the liquid coolant cannot circulate along the portions of the support 75 against which the magnets 86 are coupled, i.e. along the portions of said support 75 which precisely extend in front of the portions of the target 72 where the sputtering is the more intense, and therefore the heating up the higher (a better target cooling could in principle be carried out by arranging the magnets 86 at some distance of the support 75 instead of coupling them directly against it; but this would be done at the expense of the magnetic field likely to be applied over the sputtering face 72a of the target 72, the intensity of which would then risk to be too low for causing an efficient enhancing of the discharge plasma).

The above sputtering operation furthermore proceeds (throughout the coating of successive substrates 89) up to the piercing of the target 72, which piercing may then occur without any damage for the sputtering apparatus and/or the substrate 89 being coated, since immediately causing the automatic cut-off of the sputtering process (thanks to the control circuit 64). The optimally consumed target 72 can therefore be replaced by a new fresh one, and the sputtering process immediately restarted.

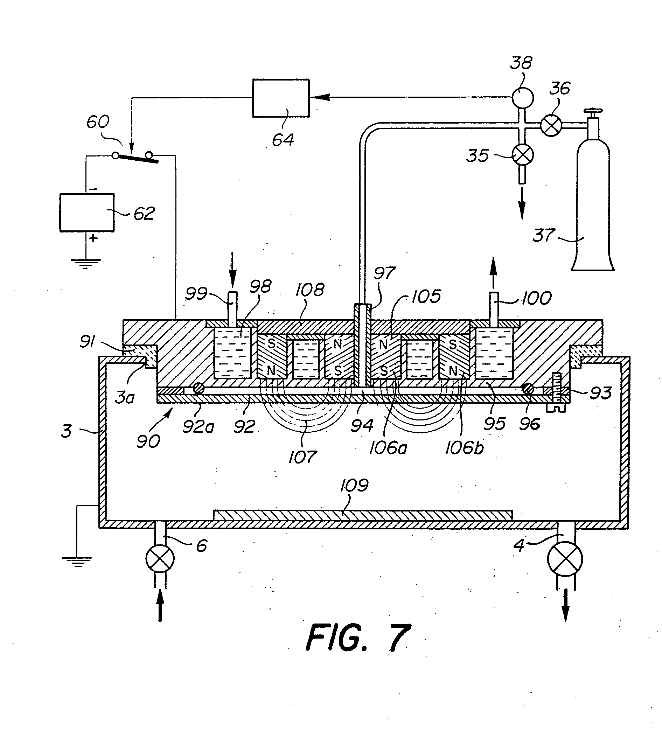

The Fig. 7 relates to a third embodiment of the apparatus of the present invention, according to which there is made use of a planar magnetron sputtering cathode designed for enabling the coating of a planar substrate disposed in front of said cathode (the elements of said embodiment unchanged with respect to those of Figs. 1 to 4 remaining allocated with the same figures of reference on the drawing).

This embodiment of Fig. 7 also comprises a sealed enclosure 3, respectively provided with an admission port 4 and an evacuation port 6. Through a circular opening 3a provided in the top of the enclosure 3 is introduced a planar magnetron sputtering cathode 90 of circular cross-section (electrically separated from the enclosure 3 by means of an insulating ring 91). This planar cathode 90 comprises a discoidal target 92 made of a material to be sputtered, arranged in the vicinity of the lower planar face of an intermediate support 95 so as to delimitate in combination therewith a tight chamber 94 of low thickness (the appropriate spacing between the target 92 and the support 95 being ensured by annular spacing element 93, while the tightness of said chamber 94 is ensured by an appropriate O-ring 96).

The intermediate support 95 in turn forms part of the wall of a plenum 98 adjoining said tight chamber 94, which plenum 98 is respectively provided with an admission port 99 and an evacuation port 100 for enabling the circulation of a liquid coolant therewithin. Against the back face of the plenum 98 is mounted a magnet assembly 105, consisting of a central discoidal magnet 106a surrounded by annular magnet 106b. These concentric magnets 106a and 106b are axially magnetized in a reverse direction from each other, so as to generate magnetic fields, the flux lines of which form a closed loop toroidal-shaped arch 107 over the planar sputtering face 92a of the target 92 (the magnet assembly 105 further comprising a discoidal soft iron plate 108 extending on the upper surface of the magnets 106a and 106b for closing the flux lines on the upper side).

The tight chamber 94 is besides connected to the outside of the enclosure 3 by means of a conduit 97 extending through the central magnet 106a and the plate 108, which conduit 97 is in turn connected to the same elements as previously (i.e., respectively, to adequate pumping means via the valve 35, to the helium source 37 via the gauged valve 36, and to the pressure gauge 38).

Against the bottom of the enclosure 3 is finally disposed a discoidal substrate 109 to be coated. This substrate 109 is connected to ground, while the sputtering cathode 90 is connected via the switch 60 to the negative high voltage source 62 whose other pole is also grounded. The apparatus is finally also provided with the control circuit 64, respectively connected to the pressure gauge 38 and to the switch 60.

The operation of the above-described apparatus is in many respects similar to those previously described, so that it needs not to be further described.

## Claims

1. An apparatus for coating substrates by high-rate cathodic sputtering, which comprises an evacuable sealed enclosure; means for evacuating said enclosure and for providing therein a rarefied gas atmosphere at a pressure capable of sustaining a glow discharge; at least one sputtering cathode and one anode distant from each other, disposed at least partially inside said enclosure or forming part thereof; means for establishing between said sputtering cathode and said anode a potential difference sufficient for generating a glow discharge therebetween; and means for enhancing a sputtering about said cathode, so as to cause a high sputtering rate, wherein said sputtering cathode comprises:

— a target made of material to be sputtered, presenting two major opposing faces of which one is designed for constituting a sputtering face,
— an intermediate support arranged in front of the face of said target opposed to said sputtering face, in such a manner as to define in combination therewith a first tight chamber of relatively low thickness, said intermediate support in turn forming part of the wall of a second tight chamber arranged adjacent to said first tight chamber,
— means for providing inside said first tight chamber an atmosphere of a gas presenting a high thermal conductivity, at a pressure higher than that prevailing in said sealed enclosure, and
— means for circulating a liquid coolant within said second tight chamber, and wherein said apparatus further comprises:
— means for detecting a sudden irruption, inside said sealed enclosure, of said high thermally-conducting gas normally contained inside said first tight chamber, and,
— means for controlling the switch-off of said apparatus as soon as said sudden irruption of gas is detected, whereby enabling said target to be sputtered up to its piercing without damage for said apparatus and/or substrates while enabling a proper target cooling throughout said sputtering.

2. The apparatus of Claim 1, wherein said gas of high thermal conductivity intended to be provided inside said first tight chamber of said sputtering cathode is chosen within the group consisting of helium, hydrogen and neon.

3. The apparatus of Claim 1, wherein the atmosphere of said gas intended to be provided inside said first tight chamber has a pressure comprised between $10^{-1}$ and 200 torr (between 13.3322 and $2.66644 \times 10^4$ Pa).

4. The apparatus of Claim 3, wherein said pressure is preferably comprised between 1 and 10 torr (between $1.33322 \times 10^2$ and $1.33322 \times 10^2$ Pa).

5. The apparatus of Claim 1, wherein said sputtering target and said intermediate support are arranged with respect to each other so that the distance between their confronting faces is comprised between 0.05 and 1 mm.

6. The apparatus of Claim 1, wherein said distance between the confronting faces of said intermediate support and said sputtering target is preferably comprised between 0.1 and 0.3 mm.

7. The apparatus of Claim 1, wherein said sputtering cathode presents a cylindrical shape, said sputtering target and said intermediate support constitutive of said cylindrical cathode presenting therefore the shape of tubes arranged coaxially with respect to each other, whereby delimitating a first tight chamber of annular cross-section therebetween.

8. The apparatus of Claim 7, wherein said cylindrical sputtering cathode is designed for extending centrally inside said apparatus, said tubular sputtering target being therefore arranged coaxially outside said tubular intermediate support.

9. The apparatus of Claim 7, wherein said cylindrical sputtering cathode is a hollow cylindrical cathode designed for extending concentrically around the central axis of said apparatus, said tubular sputtering target being therefore arranged coaxially inside said tubular intermediate support.

10. The apparatus of Claim 1, wherein said sputtering cathode presents a planar shape, said sputtering target and said intermediate support constitutive of said planar cathode presenting therefore the shape of plates arranged in front of each other, whereby delimitating a sheet-like first tight chamber therebetween.

11. The apparatus of Claim 1, wherein said means for detecting a sudden irruption of said high thermally conducting gas inside said sealed enclosure is constituted by means of measuring the pressure prevailing at any instant inside said sealed enclosure, said controlling means therefore controlling the switch-off of said apparatus as soon as said measured pressure inside said sealed enclosure undergoes a sudden rise.

12. The apparatus of Claim 1, wherein said means for detecting a sudden irruption of said high thermally conducting gas inside said sealed enclosure is constituted by means for measuring the pressure prevailing at any instant inside said first tight chamber, said controlling means therefore controlling the switch-off of said apparatus as soon as said measured pressure inside said tight chamber undergoes a sudden decrease.

13. The apparatus of Claim 1, wherein said means for detecting a sudden irruption of said high thermally conducting gas inside said sealed enclosure is constituted by spectroscopical means for detecting the apparition of the characteristic light likely to be emitted by said high thermally conducting gas when submitted to an electrical discharge at its entrance inside said sealed enclosure, said controlling means therefore controlling the switch-off of said apparatus as soon as said characteristic light emission occurs.

14. The apparatus of Claim 1, wherein said enhancing means are constituted by means for applying magnetic fields in the interspace between the cathode and the anode.

15. The apparatus of Claim 1, wherein said magnetic means are constituted by permanent magnet assemblies arranged behind the back of said intermediate support, in such a manner as to enable the establishing of tunnel-shaped magnetic fields extending adjacent to the sputtering face of said target.

16. A sputtering cathode for a high-rate sputtering apparatus for substrate coating, adapted for being consumed up to its piercing without damage for said apparatus and/or substrates while capable of being properly cooled throughout said consumption, wherein said sputtering cathode comprises:

— a target made of a material to be sputtered, presenting two major opposing faces of which one is designed for constituting a sputtering face,
— an intermediate support arranged in front of the face of said target opposed to said sputtering face, in such a manner as to define in combination therewith a first tight chamber of relatively low thickness, said intermediate support in turn forming part of the wall of a second tight chamber arranged adjacent to said first tight chamber,
— means for providing inside said first tight chamber an atmosphere of a gas presenting a high thermal conductivity and,
— means for circulating a liquid coolant within said second tight chamber.

**Patentansprüche**

1. Vorrichtung zur Beschichtung von Substraten mittels Hochleistungskathodenzerstäubung, die einen evakuierbaren abgedichteten Behälter, Einrichtungen zum Evakuieren des Behälters und zur Schaffung einer verdünnten Gasatmosphäre in diesem mit einem Druck, der geeignet ist, eine Glühentladung zu unterstützen, wenigstens eine Zerstäuberkathode und eine Anode, die einen Abstand voneinander haben, wenigstens teilweise innerhalb des Gehäuses angeordnet sind oder einen Teil davon bilden, Anordnungen, um zwischen der Zerstäuberkathode und der Anode eine Potentialdifferenz aufzubauen, die ausreicht, zwischen ihnen eine Glühentladung zu erzeugen, und Anordnungen umfaßt, um die Zerstäubung an der Kathode zu unterstützen, um so ein hohes Zerstäubungsausmaß zu bewirken, dadurch gekennzeichnet, daß die Zerstäuberkathode umfaßt:

— ein Target aus einem zu zerstäubenden Material und mit zwei einander gegenüberliegenden Hauptflächen, von denen eine als Zerstäuberfläche ausgebildet ist,
— einen Zwischenträger, der vor der Targetfläche angeordnet ist, die der Zerstäuberfläche gegenüberliegt, derart, daß in Kombination damit eine erste dichte Kammer relativ geringer Dicke begrenzt wird, wobei der Zwischenträger seinerseits Teil der Wand einer zweiten dichten Kammer bildet, die der ersten dichten Kammer benachbart angeordnet ist,
— Anordnungen, um innerhalb der ersten dichten Kammer eine Atmosphäre eines Gases mit einer hohen thermischen Leitfähigkeit bei einem Druck zu schaffen, der höher ist als jener der im abgedichteten Behälter vorherrscht, und
— Anordnungen zum Zirkulieren eines flüssigen Kühlmittels in der zweiten dichten Kammer, und daß die Vorrichtung weiters umfaßt:
— Anordnungen zur Festellung eines plötzlichen Ausbruches des thermisch hochleitenden Gases innerhalb des abgedichteten Behälters, welches Gas normalerweise innerhalb der ersten dichten Kammer gehalten ist, und
— Anordnungen zur Regelung der Abschaltung der Vorrichtung sobald ein plötzlicher Gasausbruch festgestellt worden ist, wodurch das Target ohne Schädigung für die Vorrichtung und/oder der Substrate bis zur Durchlöcherung zerstäubt werden kann, wobei eine geeignete Targetkühlung während der Zerstäubung möglich ist.

2. Vorrichtung nach Anspruch 1, dadurch gekennzeichnet, daß das Gas mit hoher thermischer Leitfähigkeit, das innerhalb der ersten dichten Kammer der Zerstäubungskathode vorgesehen werden soll, aus der Gruppe bestehend aus Helium, Wasserstoff und Neon gewählt wird.

3. Vorrichtung nach Anspruch 1, dadurch gekennzeichnet, daß die Atmosphäre des Gases, das in der ersten dichten Kammer vorgesehen werden soll, einen Druck zwischen $10^{-1}$ und 200 Torr (zwischen 13,3322 und $2,66644 \times 10^4$Pa) hat.

4. Vorrichtung nach Anspruch 3, dadurch gekennzeichnet, daß der Druck vorzugsweise zwischen 1 und 10 Torr (zwischen $1,33322 \times 10^2$ und $1,33322 \times 10^3$Pa) liegt.

5. Vorrichtung nach Anspruch 1, dadurch gekennzeichnet, daß das Zerstäubertarget und der Zwischenträger zueinander so angeordnet sind, daß der Abstand zwischen ihren einander gegenüberliegenden Flächen zwischen 0,05 und 1 mm ist.

6. Vorrichtung nach Anspruch 1, dadurch gekennzeichnet, daß der Abstand zwischen den einander gegenüberliegenden Flächen des Zwischenträgers und des Zerstäubertargets vorzugsweise zwischen 0,1 und 0,3 mm beträgt.

7. Vorrichtung nach Anspruch 1, dadurch gekennzeichnet, daß die Zerstäuberkathode zylindrische Form hat, so daß daher das Zerstäubertarget und der Zwischenträger, Bestandteile der zylindrischen Kathode, die Form von Rohren haben, die zueinander koaxial angeordnet sind, wodurch dazwischen eine erste dichte Kammer mit ringförmigem Querschnitt begrenzt ist.

8. Vorrichtung nach Anspruch 7, dadurch gekennzeichnet, daß die zylindrische Zerstäuberkathode so ausgebildet ist, daß sie sich mittig innerhalb der Vorrichtung erstreckt, so daß daher das rohrförmige Zerstäubertarget koaxial außerhalb der rohrförmigen Zwischenträgers angeordnet ist.

9. Vorrichtung nach Anspruch 7, dadurch gekennzeichnet, daß die zylindrische Zerstäuberkathode eine hohlzylindrische Kathode ist, die so ausgebildet ist, daß sie sich konzentrisch um die Mittelachse der Vorrichtung erstreckt, so daß das rohrförmige Zerstäubertarget daher koaxial innerhalb des rohrförmigen Zwischenträgers angeordnet ist.

10. Vorrichtung nach Anspruch 1, dadurch gekennzeichnet, daß die Zerstäuberkathode eine ebene Form hat, so daß daher das Zerstäubertarget und der Zwischenträger, die Bestandteile der ebenen Kathode sind, die Form von Platten haben, die hintereinander angeordnet sind, wodurch eine plattenartige erste dichte Kammer dazwischen begrenzt wird.

11. Vorrichtung nach Anspruch 1, dadurch gekennzeichnet, daß die Anordnungen zur Feststellung eines plötzlichen Ausbruches des thermisch hochleitfähigen Gases innerhalb des abgedichteten Behälters durch Vorrichtungen zur Messung des zu jedem Zeitpunkt innerhalb des abgedichteten Behälters herrschenden Druckes gebildet sind, wobei die Regelungsanordnungen die Abschaltung der Vorrichtung daher regeln, sobald der gemessene Druck innerhalb des abgedichteten Behälters einen plötzlichen Anstieg aufweist.

12. Vorrichtung nach Anspruch 1, dadurch gekennzeichnet, daß die Anordnungen zur Festellung eines plötzlichen Ausbruches des thermisch hochleitfähigen Gases innerhalb des abgedichteten Behälters durch Vorrichtungen zur Messung des es an jedem Zeitpunkt innerhalb der ersten dichten Kammer herrschenden Druckes gebildet werden, wobei die Regelungsanordnungen daher die Abschaltung der Vorrichtung regeln, sobald der gemessene Druck innerhalb der dichten Kammer einen plötzlichen Abfall aufweist.

13. Vorrichtung nach Anspruch 1, dadurch gekennzeichnet, daß die Anordnungen zur Feststellung eines plötzlichen Ausbruches des thermisch hochleitfähigen Gases innerhalb des abgedichteten Behälters durch spektroskopische Vorrichtungen zur Feststellung des Auftretens des charakteristischen Lichtes gebildet werden, das von dem thermisch hochleitfähigen Gas emittiert werden sollte, wenn es einer elektrischen Entladung bei seinem Eintritt in den abgedichteten Behälter unterworfen wird, wobei die Regelungsanordnungen daher die Abschaltung der Vorrichtung regeln, sobald die charakteristische Lichtemission auftritt.

14. Vorrichtung nach Anspruch 1, dadurch gekennzeichnet, daß die Unterstützungsanordnungen durch Anordnung zum Hervorrufen von Magnetfeldern im Zwischenraum zwischen der Kathode und der Anode gebildet werden.

15. Vorrichtung nach Anspruch 1, dadurch gekennzeichnet, daß die magnetischen Anordnungen durch Permanentmagnetanordnungen hinter dem Zwischenträger gebildet werden, derart daß tunnelförmige Magnetfelder gebildet werden können, die sich nahe der Zerstäuberfläche des Targets erstrecken.

16. Zerstäuberkathode für eine Hochleistungszerstäubungsvorrichtung zur Substratbeschichtung, die bis zu ihrer Durchlöcherung ohne Schädigung der Vorrichtung und/oder der Substrate verbraucht werden kann, jedoch während des Verbrauches in geeigneter Weise gekühlt werden kann, dadurch gekennzeichnet, daß die Zerstäuberkathode umfaßt:

— ein Target aus einem zu zerstäubenden Material mit zwei einander gegenüberliegenden Hauptflächen, von denen eine als Zerstäuberfläche ausgebildet ist,

— einen Zwischenträger der vor der Targetfläche angeordnet ist, die der Zerstäuberfläche gegenüberliegt, derart daß in Kombination damit eine erste dichte Kammer relativ geringer Dicke begrenzt wird, wobei der Zwischenträger seinerseits Teil der Wand einer zweiten dichten Kammer bildet, die der ersten dichten Kammer benachbart angeordnet ist,

— Anordnungen, um innerhalb der ersten dichten Kammer eine Atmosphäre eines Gases mit einer hohen thermischen Leitfähigkeit zu schaffen, und

— Anordnungen zum Zirkulieren eines flüssigen Kuhlmittels in der zweiten dichten Kammer.

**Revendications**

1. Appareil pour le revêtement de substrats par pulvérisation cathodique à haute vitesse comprenant une enceinte étanche dans laquelle on peut faire le vide; des moyens pour faire le vide dans ladite enceinte et pour y établir une atmosphère gazeuse raréfiée et à une pression appropriée à la formation d'une décharge luminescente; au moins une cathode à pulvériser et une anode séparée de celle-ci et placée au moins en partie dans ladite enceinte ou constituant une partie de celle-ci; des moyens pour appliquer entre ladite cathode à pulvériser et ladite anode une différence de potentiel suffisante pour que se forme une décharge luminescente entre-elles; et des moyens pour amplifier la pulvérisation de cette cathode de manière à provoquer une haute vitesse de pulvérisation, suivant lequel ladite cathode à pulvériser comprend:

— une cible composée d'un matériau pulvérisable ayant deux faces principales opposées desquelles l'une est prévue pour être pulvérisée,

— un support intermédiaire disposé devant la face de ladite cible qui est opposée à la face pulvérisable de manière à définir, en combinaison avec celle-ci, une première chambre étanche d'épaisseur relativement faible, ledit support intermédiaire faisant, à son tour, partie de la cloison d'une seconde chambre étanche adjacente à la première chambre étanche,

— des moyens pour établir dans la première chambre étanche une atmosphère gazeuse de haute conductivité thermique dont la pression est plus élevée que celle régnant dans ladite enceinte étanche, et

— des moyens pour mettre en circulation un liquide réfrigérant dans la seconde chambre étanche, ledit appareil comprenant encore

— des moyens pour détecter l'irruption imprévue dans ladite enceinte étanche dudit gas hautement thermiquement conducteur normalement confiné dans ladite première chambre étanche, et

— des moyens pour contrôler l'arrêt dudit appareil dès détection de ladite irruption de gaz, de manière que ladite cible puisse être pulvérisée jusqu'à perforation sans inconvénient pour ledit appareil et/ou substrat tout en assurant que la cible soit bien refroidie tout au long de ladite pulvérisation.

2. Appareil suivant la revendication 1, dans lequel ledit gaz à haute conducibilité thermique devant être contenu dans ladite première chambre étanche de ladite cathode à pulvériser est choisi dans le groupe de l'hélium, de l'hydrogène et du néon.

3. Appareil suivant la revendication 1, dans lequel la pression d'atmosphère régnant dans ledit gaz devant être contenu dans ladite première chambre étanche est comprise entre $10^{-1}$ et 200 Torr (13,3322 et $2,66644 \times 10^4$ Pa).

4. Appareil suivant la revendication 3, dans lequel la pression est de préférence comprise entre 1 et 10 Torr ($1,33322 \times 10^2$ et $1,33322 \times 10^3$ Pa).

5. Appareil suivant la revendication 1, dans lequel ladite cible à pulvériser et ledit support intermédiaire sont agencés l'un par rapport à l'autre de manière que la distance entre leurs parois se faisant face est comprise entre 0,05 et 1 mm.

6. Appareil suivant la revendication 1, dans lequel la distance entre les parois, se faisant face, dudit support intermédiaire et de ladite cible à pulvériser est de préférence comprise entre 0,1 et 0,3 mm.

7. Appareil suivant la revendication 1, dans lequel ladite cathode à pulvériser est de forme cylindrique, ladite cible à pulvériser et ledit support intermédiaire ayant ainsi la forme de tubes coaxiaux l'un à l'autre agencés de manière à délimiter entre-eux une première chambre étanche de section annulaire.

9. Appareil suivant la revendication 7, dans lequel ladite cathode cylindrique à pulvériser est conçue de manière à se prolonger centralement dans ledit appareil de manière que ladite cible à pulvériser soit disposée coaxialement en dehors dudit support intermédiaire.

9. Appareil suivant la revendication 7, dans lequel ladite cathode à pulvériser est une cathode cylindrique creuse conçue pour se prolonger concentriquement autour de l'axe central dudit appareil, ladite cible à pulvériser tubulaire étant ainsi disposée coaxialement en dedans dudit support intermédiaire.

10. Appareil suivant la revendication 1, dans lequel la cathode à pulvériser présente une forme plane, ladite cible à pulvériser et ledit support intermédiaire constituant ladite cathode plane sont en forme de plaques disposées en face l'une de l'autre, de manière à délimiter entre elles une première chambre étanche en forme de feuille.

11. Appareil suivant la revendication 1, dans lequel lesdits moyens pour détecter une irruption inopinée dudit gaz thermiquement conducteur dans ladite enceinte étanche sont constitués de moyens de mesure de la pression régnant à tout instant dans ladite enceinte étanche, le tout de manière que ces moyens contrôlent et arrêtent ledit appareil dès que la pression mesurée dans ladite enceinte étanche augmente subitement.

12. Appareil suivant la revendication 1, dans lequel lesdits moyens pour détecter une irruption inopinée dudit gaz thermiquement conducteur dans ladite enceinte étanche sont constitués par des moyens de mesure de la pression régnant à tout moment dans ladite première chambre étanche, le tout de manière que ces moyens contrôlent et arrêtent ledit appareil dès que la pression mesurée dans ladite première chambre étanche diminue subitement.

13. Appareil suivant la revendication 1, dans lequel lesdits moyens pour détecter une irruption inopinée dudit gaz thermiquement conducteur dans ladite enceinte étanche sont constitués par des moyens spechoscopiques qui détectent l'apparition d'un rayonnement caractéristique qu'émettrait ledit gaz thermiquement conducteur au cas où il serait soumis à une décharge électrique lor de sa pénétration dans ladite enceinte étanche, le tout de manière que ces moyens contrôlent et arrêtent ledit appareil dès que cette émission lumineuse caractéristique apparaît.

14. Appareil suivant la revendication 1, dans lequel lesdits moyens d'amplification sont constitués par des moyens pour appliquer des champs magnétiques dans l'espace intermédiaire séparant la cathode de l'anode.

15. Appareil suivant la revendication 1, dans lequel lesdits moyens magnétiques sont constitués par des assemblages d'aimants permanents arrangés derrière la partie arrière dudit support intermédiaire, de façon à permettre que se forment des champs magnétiques en forme de tunnel se prolongeant en position adjacente à la face de ladite cible qui est pulvérisée.

16. Cathode de pulvérisation destinée à un appareil pour revêtir un substrat par pulvérisation à haute vitesse, agencé de manière qu'elle puisse être érodée jusqu'à perforation sans inconvénient pour ledit appareil et/ou substrat tout en pouvant être refroidie de manière convenable tout au long de ce processus d'érosion, cette cathode comprenant:

— une cible faite d'un matériau à pulvériser et ayant deux faces principales opposées desquelles l'une est prévue pour être pulvérisée,
— un support intermédiaire disposé devant la face de ladite cible qui est opposée à la face pulvérisable de manière à définir, en combinaison avec celle-ci, une première chambre étanche d'épaisseur relativement faible, ledit support intermédiaire faisant, à son tour, partie de la cloison d'une seconde chambre étanche adjacente à la première chambre étanche,
— des moyens pour établir dans la première chambre étanche une atmosphère gazeuse de haute conductivité thermique, et
— des moyens pour mettre en circulation un liquide réfrigérant dans la seconde chambre étanche.

**0 046 154**

FIG. 1

FIG. 2

FIG. 3

FIG. 4

FIG. 5

FIG. 6

0 046 154

FIG. 7